# EUROPÄISCHE PATENTSCHRIFT

(11) **EP 3 761 349 B1**
(45) Veröffentlichungstag und Bekanntmachung des Hinweises auf die Patenterteilung: **12.04.2023**
(21) Anmeldenummer: 20184039.4
(22) Anmeldetag: 03.07.2020
(51) Int. Cl.: H01L 21/67, H01L 21/683

(54) **VERFAHREN ZUR HERSTELLUNG VON HALBLEITERBAUELEMENTEN ZUR AUSBEUTESTEIGERUNG BEIM MIKROTRANSFERDRUCK**
METHOD FOR MANUFACTURING SEMICONDUCTOR MODULES FOR INCREASING YIELD IN MICROTRANSFER PRINTING
PROCÉDÉ DE FABRICATION DE COMPOSANTS SEMI-CONDUCTEURS PERMETTANT D'AUGMENTER LE RENDEMENT DE L'IMPRESSION PAR MICROTRANSFER

(30) Priorität: 05.07.2019 DE 102019118270
(43) Veröffentlichungstag der Anmeldung: 06.01.2021
(73) Patentinhaber: X-FAB Semiconductor Foundries GmbH, 99097 Erfurt (DE)
(72) Erfinder: LERNER, Ralf, 99085 Erfurt (DE)
(74) Vertreter: Leonhard, Frank Reimund

(56) Entgegenhaltungen:
- EP-A1- 3 425 618
- WO-A1-2013/161061
- DE-A1-102016 109 459
- DE-T5-112017 004 029
- US-A1- 2004 118 512
- US-A1- 2011 097 828
- US-A1- 2017 200 711
- US-A1- 2018 108 541

## Beschreibung

Die Erfindung betrifft ein Verfahren zur Herstellung von Halbleiterbauelementen zur Ausbeutesteigerung beim Mikrotransferdruck.

Mikrotransferdruck (µTP - mikro transfer printing) umfasst Methoden bei denen mithilfe eines Transferstempels mikroskalige Komponenten bzw. Bauelemente auf einem nicht-nativen Substrat montiert werden können. Der Mikrotransferdruck ist ein hochskalierbares Verfahren, bei dem eine Vielzahl von Bauelementen in einem Verfahrensschritt miteinander verbunden werden kann.

Hierbei bezeichnet die Ausbeute eines Herstellverfahren von Halbleiterbauelementen, beispielsweise von integrierten Schaltkreisen (IC - Integrated Circuit), ein Maß, anhand dessen der Produktionsprozess bzw. das Chipdesign bewertet werden kann. Allgemein ergibt sich die Ausbeute einer betrachteten Halbleiterscheibe aus dem Verhältnis der Anzahl von funktionalen Bauelementen zu der Anzahl der Bauelemente, die insgesamt auf der Halbleiterscheibe (Wafer) hergestellt werden können, eingeschlossen der nicht-funktionalen Bauelemente.

Die gesamte Ausbeute bei der Herstellung von integrierten Schaltkreisen mittels Mikrotransferdruck ergibt sich aus der Betrachtung aller Verfahrensschritte des Gesa mtprozesses:
- die Ausbeute A, die sich nach dem Freiätzen der Bauelemente ergibt,
- die Ausbeute B des eigentlichen Transferdrucks und
- die Ausbeute C, die auf dem nicht-nativen Substrat erreicht werden konnte.

Die sich aus den drei Komponenten A, B und C zusammensetzende Gesamtausbeute wird in erster Linie von der zahlenmäßig schlechtesten Ausbeute bestimmt und ist nach oben begrenzt. Die Gesamtausbeute beim Transferdruck von bspw. Gallium Nitrid (GaN) Bauelementen (als jüngeres Verfahren in der Industrie) ist geringer als bei bereits ausgereiften Verfahren, z.B. der Transferdruck von CMOS Bauelementen.

Aus dem Stand der Technik sind verschiedene Mikrotransferdruck-Verfahren bekannt. Insbesondere sind solche Verfahren bekannt, bei denen mittels eines Elastomer-Stempels die Komponenten von einer ersten Halbleiterscheibe auf ein nicht-natives Substrat überführt werden, meist eine zweite Halbleiterscheibe.

US 2009/0294803 A1, DE 11 2011 101 135 T5 und US 8 664 699 B2 beschreiben die Technik des Überführungsdrucks, bei welchem Halbleiter-Bauelemente von einer ersten Halbleiterscheibe mittels eines aus Elastomermaterial hergestellten Stempels auf ein neues Substrat überführt werden können. Dieses zweite Substrat könnte beispielsweise auch eine zweite Halbleiterscheibe sein. Die zu überführenden Bauelemente werden zunächst maskiert und seitlich frei geätzt. Bei diesem Ätzschritt wird bis auf kleine so genannte brechbare Anbinde-Elemente um das Bauelement herum geätzt. In einem nächsten Ätzschritt wird unterhalb des Bauelements Material weg geätzt, so dass das Bauelement nunmehr im Wesentlichen frei liegt und nur noch von den Anbinde-Elementen mechanisch gehalten wird. Einige Bauelemente werden in konformen Kontakt mit der Oberfläche des Stempels gebracht, so dass diese Bauelemente durch Adhäsion am Stempel von der ersten Halbleiterscheibe abgelöst werden können, d.h. die Anbinde-Elemente werden gebrochen. Anschließend werden die am Stempel anhaftenden Bauelemente in konformen Kontakt mit dem neuen Trägersubstrat gebracht und dort fixiert.

Mit diesem Verfahren ist es beispielsweise möglich, mehrere auf einem ersten Trägersubstrat hergestellte Bauelemente, z.B. Gallium-Nitrid-Transistoren (GaN-Transistoren) pro Stempelvorgang von einer ersten Halbleiterscheibe auf eine zweite Halbleiterscheibe zu überführen, wobei sich die erste und die zweite Halbleiterscheibe in einer oder mehreren Eigenschaften voneinander unterscheiden können. Beispielsweise können sich die Halbleiterscheiben, die als entsprechende Trägersubstrate dienen, in der Materialart, in der Kristallorientierung, im Scheibendurchmesser und in der Scheibendicke unterscheiden, und es werden gegebenenfalls unterschiedliche Prozesstechniken eingesetzt, um auf den jeweiligen Trägersubstraten die gewünschten Bauelemente bzw. Komponenten herzustellen. Nach dem Überführungsdruck können in weiteren Halbleiterprozess-Verarbeitungsschritten beispielsweise Isolationsschichten und/oder leitfähige Schichten über dem zweiten Trägersubstrat, das nunmehr an geeigneten Positionen die zuvor überführten Bauelemente aufweist, abgeschieden und anschließend strukturiert werden, um die für die gewünschte Funktion erforderlichen mechanischen und/oder elektrischen und/oder optischen Verbindungen herzustellen. Die Bearbeitung auf der Basis des gesamten Trägersubstrats ermöglicht eine kostengünstige Fertigung, da die Bearbeitung für eine Vielzahl von zusammengesetzten Bauelementen, z.B. von Schaltkreisen, im gleichen Arbeitsschritt erfolgt, wie dies auch für die Herstellung standardmäßiger integrierter Schaltungen bekannt ist. Beispielsweise können GaN-Transistoren mit hoher Elektronenbeweglichkeit und damit hoher Leitfähigkeit durch eine mit Kontaktdurchführungen versehenen Isolationsschicht nach ihrer Überführung auf ein anderes geeignetes Trägersubstrat abgedeckt, strukturiert und mit einer Metallschicht verdrahtet werden.

US 7 932 123 B2 beschreibt Verfahren, bei denen mit mehreren so genannter "Ablöseschichten oder Freigabeschichten" (release layers) die funktionalen Strukturen, die auf einem geeigneten Trägersubstrat hergestellt wurden, "druckbar" gemacht werden, so dass sie auf ein weiteres Trägersubstrat überführt werden können.

US 7 943 491 B2 und US 2013/0069275 A1 beschreiben ein kinetisch gesteuertes Verfahren, wobei durch die Ablösegeschwindigkeit bzw. Separationsgeschwindigkeit die auftretenden Adhäsionskräfte zwischen einem zu übertragenden Bauelement und dem Transferstempel verändert werden, um die zu übertragenden Bauelemente zeitweilig am Stempel zu befestigen und schließlich endgültig auf dem Empfänger zu fixieren. Bei schneller Ablösung werden hohe Adhäsionskräfte erzeugt, so dass die Bauelemente am Stempel temporär anhaften und vom Spender gelöst werden. Andererseits wird durch eine geringe Separationsgeschwindigkeit und damit durch eine kleine Adhäsionskraft ein Ablösen der Bauelemente von dem Überführungsstempel erreicht.

US 7 799 699 B2 beschreibt das Freiätzen von AIGaN/GaN-Hetero-Bauelementen auf (111) Silizium. Durch eine geeignete Maskierung und vertikales Plasma-Ätzen werden freiliegende, d.h., nicht maskierte, Gräben neben dem Bauelement geätzt. In horizontaler Richtung werden die Bauelemente durch eine Ätzung des Silizium-Trägersubstrats mit Tetramethylammonium-hydroxid (TMAH) unter dem Bauelement frei geätzt. Eine mechanische Fixierung in horizontaler Richtung erfolgt durch geeignete Unterbrechungen der Gräben. Dies können Materialstege oder Anbinde-Elemente sein, die nicht weg geätzt werden.

US 2013/0210194 A1 offenbart ein elektrostatisches Transfer-Verfahren und bezieht sich auf das Transfer-Print Verfahren mit elastomeren Stempeln. Es wird ein Verfahren beschrieben mit einem ersten Träger mit darauf in einem Raster bereitgestellten ersten Bauelementen und einem zweiten Träger mit funktionalen Bauelementen, wie Transistoren, als zweiten Bauelementen, ebenfalls im Raster gebildet. Das Ablösen vom ersten Träger erfolgt mit einem Kopf/Stempel. Unter Beibehaltung des Rasters werden mehrere der ersten Bauelemente auf den zweiten Träger aufgebracht. Weitere erste Bauelemente, die auf dem ersten Träger bisher nicht abgelöst wurden, stehen zum Aufbringen an noch nicht belegte Positionen auf dem zweiten Träger bereit.

EP 2 339 614 A1 zeigt ein Transfer-Verfahren mit einem ersten Träger und darauf in einem Raster hergestellte erste Bauelementen, wie MEMS oder CMOS, und mit einem zweiten Träger, wie einem PCB oder einem Bauelementträgersubstrat, mit zweiten Bauelementen, wobei ein weiterer Träger die Bauelemente vom ersten Träger ablöst und auf den zweiten Träger aufbringt.

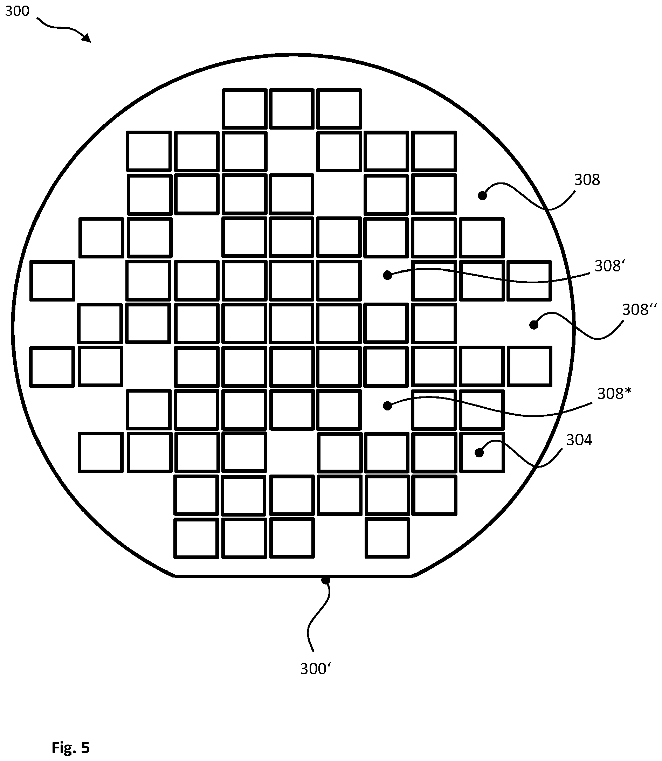

WO 2010/059781 A1 beschreibt verschiedene Einflussfaktoren auf die Ausbeute des eigentlichen Überführungsdruckprozesses: "Shear offset" in Figur 5 bzw. die "delamination rate" und die "transfer surface". Die Ausbeuten der beiden beteiligten Wafer, die erste und die zweite Halbleiterscheibe werden dabei nicht berücksichtigt.

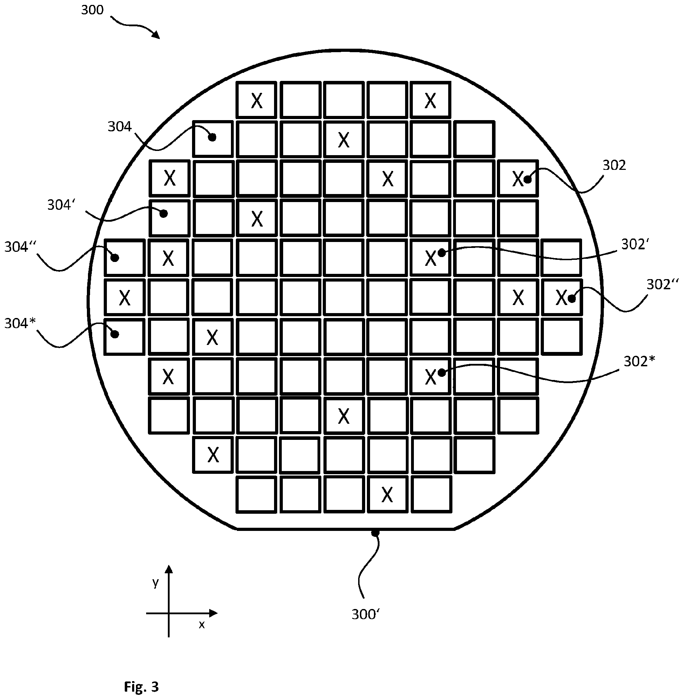

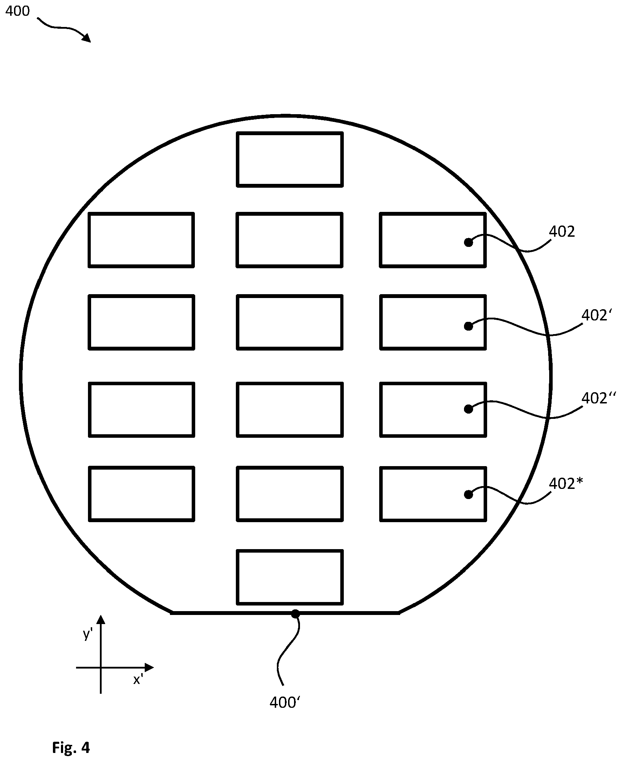

Ähnlich wird auch in US 9 827 799 B2 die Ausbeute des eigentlichen Überführungsdrucks betrachtet. Dabei werden die Einflüsse einer Opferschicht in Figur 3a (vgl. Spalte 7, Zeile 63) und der Einfluss der Ätzzeit in Figur 4 dargestellt (vgl. Spalte 8, Zeile 21).

EP3 425 618 A1 offenbart ein Verfahren zur Herstellung eines Anzeigeelements, bei dem ein zweiter Bestückungszyklus mit einer oder mehrerer ausgewählter zweiter LEDs und deren Platzierung auf einem Anzeigesubstrat durchgeführt wird.

Bei den aus dem Stand der Technik bekannten Verfahren wird der Fokus auf Ausbeute B gelegt, also die Ausbeute des eigentlichen Transferdrucks. Der entsprechende Stempel, der für den (eigentlichen) Transferdruck verwendet wird, wird in konformen Kontakt mit der Oberfläche einer ersten Halbleiterscheibe bzw. den darauf befindlichen Halbleiterbauelementen gebracht und durch eine Adhäsion am Stempel können die Halbleiterbauelemente von der ersten Halbleiterscheibe gelöst und auf die zweite Halbleiterscheibe übertragen werden. Die Adhäsion zwischen den Halbleiterbauelementen und dem Stempel ist stark von der Delaminationsrate [mm/s] abhängig: mit steigender Delaminationsrate (Trenngeschwindigkeit) sind die Adhäsionskräfte zwischen Stempel und dem zu transferierenden Halbleiterbauelement größer als die Anbindekräfte zwischen dem Halbleiterbauelement und Substrat, so dass die Halbleiterbauelemente abgelöst und übertragen werden können. Sowohl funktionale als auch nicht-funktionale Bauteile werden hierbei von der ersten Halbleiterscheibe auf die zweite Halbleiterscheibe abgelöst und übertragen.

**Eine Aufgabe des beanspruchten Verfahrens** liegt darin, eine Ausbeutesteigerung bei der Herstellung von Mikrobauelementen im Mikrotransferdruck zu bewirken, insbesondere bei der Herstellung von solchen Mikrobauelementen, bei denen die zahlenmäßig schlechteste Ausbeute durch die Ausbeute bestimmt wird, die sich nach dem Freiätzen der Bauelemente auf der ersten Halbleiterscheibe ergibt.

**Gelöst wird die Aufgabe** durch ein Verfahren zur Herstellung von Halbleiterbauelementen nach Anspruch 1.

Das Verfahren kann mehrere Verfahrensschritte umfassen. Das Verfahren kann Verfahrensschritte umfassen, die Vorbereitungsschritte (siehe bspw. Anspruch 1: a', b' ...), Mikrotransferdruckschritte (siehe bspw. Anspruch 1: a, b, ...) und Nachbearbeitungsschritte (siehe bspw. Anspruch 16: a", b" ...) umfassen.

Das Verfahren umfasst das Bereitstellen von einer ersten Halbleiterscheibe mit ersten überwiegend funktionalen Bauelementen und wenigen ersten nicht-funktionalen Bauelementen in einem ersten Raster. Das Verfahren umfasst das Bereitstellen einer zweiten Halbleiterscheibe mit zweiten Bauelementen. Zudem beinhaltet das Verfahren das Entfernen der nicht-funktionalen ersten Bauelemente von der ersten Halbleiterscheibe in ersten jeweils individuellen Transferdruckschritten. Das Verfahren enthält das Übertragen einer Vielzahl der ersten funktionalen Bauelemente von der ersten Halbleiterscheibe auf die zugehörigen zweiten Bauelemente der zweiten Halbleiterscheibe in einem zweiten Transferdruckschritt. Weiterhin umfasst das Verfahren das Übertragen von einzelnen funktionalen ersten Bauelementen der ersten Halbleiterscheibe auf zweite Bauelemente, die ohne gedruckte erste Bauelemente sind, in dritten jeweils individuellen Tra nsferd rucksch ritten.

"Überwiegend funktionale erste Bauelemente" bedeutet in diesem Kontext, dass sich zahlenmäßig betrachtet mehr funktionale erste Bauelemente auf der ersten Halbleiterscheibe befinden als nicht-funktionale Bauelemente ("wenige nicht-funktionale Bauelemente"). Insbesondere können anteilig betrachtet mindestens 80 % aller ersten Bauelemente auf der ersten Halbleiterscheibe funktional und maximal 20 % der ersten Bauelemente nicht-funktional sein, damit "überwiegend funktionale Bauelemente " vorhanden sind.

Die erste Halbleiterscheibe kann eine kreisrunde oder quadratische Scheibe sein. Die erste Halbleiterscheibe kann aus ein- oder polykristallinen Materialien gefertigt sein. Die erste Halbleiterscheibe kann so ausgestaltet sein, dass sie als Substrat (Grundplatte) für elektronische Bauelemente dient, bevorzugt integrierten Schaltkreisen, mikromechanischen Bauelementen oder photoelektrischen Beschichtungen. Die erste Halbleiterscheibe kann eine Dicke von bis zu 1,0 mm haben, bevorzugt eine Dicke zwischen 0,275 bis 0,925 mm. Der Durchmesser der ersten Halbleiterscheibe kann zwischen 50,0 mm und 450,0 mm liegen, bevorzugt einen Durchmesser von 100,0 bis 300,0 mm betragen. Die erste Halbleiterscheibe kann aus monokristallinem Silizium, Siliciumcarbid, Gallium-Arsenid oder Indiumphosphid bestehen.

Die ersten Bauelemente können integrierte Schaltkreise oder mikromechanische Bauelemente sein. Funktionale erste Bauelemente können solche sein, die ihrem zweckmäßigen Gebrauch dienen, bspw. eine funktionale Schere ist eine solche, die etwas zerschneiden kann. Als Umkehrschluss ergibt sich, dass nicht-funktionale Bauelemente Bauelemente sein können, die nicht ihrem zweckgemäßen Gebrauch dienen können.

Die ersten Bauelemente (sowohl funktionale als auch nicht-funktionale) können in einem Raster in einer Ebene liegend angeordnet sein. Die Ebene kann deckungsgleich in der Ebene liegen, die durch eine Oberfläche der ersten Halbleiterscheibe aufgespannt wird. Die Koordinaten innerhalb der Ebene können durch ein in der Ebene liegendes x,y-Koordinatensystem eindeutig definiert bzw. ausgedrückt werden. Das Raster kann sich als Netz aus Linien zur Zerlegung der Oberfläche der ersten Halbleiterscheibe in eine Vielzahl von Segmenten ergeben, so dass Umrisse der ersten Bauelemente auf der ersten Halbleiterscheibe definiert werden.

Die zweite Halbleiterscheibe kann eine kreisrunde oder quadratische Scheibe sein. Die zweite Halbleiterscheibe kann aus ein- oder polykristallinen Materialien gefertigt sein. Die zweite Halbleiterscheibe kann so ausgestaltet sein, dass sie als Substrat (Grundplatte) für elektronische Bauelemente dient, bevorzugt integrierten Schaltkreisen, mikromechanischen Bauelementen oder photoelektrischen Beschichtungen. Die zweite Halbleiterscheibe kann eine Dicke von bis zu 1,0 mm haben, bevorzugt eine Dicke zwischen 0,275 bis 0,925 mm betragen. Der Durchmesser der zweiten Halbleiterscheibe kann zwischen 50,0 mm und 450,0 mm liegen, bevorzugt einen Durchmesser von 100,0 bis 300,0 mm betragen. Die zweite Halbleiterscheibe kann aus monokristallinem Silizium, Siliciumcarbid, Gallium-Arsenid oder Indiumphosphid bestehen.

Die zweiten Bauelemente können integrierte Schaltkreise oder mikromechanische Bauelemente sein.

Die zweiten Bauelemente können in einem Raster in einer Ebene liegend angeordnet sein. Die Ebene kann deckungsgleich in der Ebene liegen, die durch eine Oberfläche der zweiten Halbleiterscheibe aufgespannt wird. Die Koordinaten innerhalb der Ebene können durch ein in der Ebene liegendes x,y-Koordinatensystem eindeutig definiert bzw. ausgedrückt werden. Das Raster kann sich als Netz aus Linien zur Zerlegung der Oberfläche der zweiten Halbleiterscheibe in eine Vielzahl von Segmenten ergeben, so dass Umrisse der zweiten Bauelemente auf der zweiten Halbleiterscheibe definiert werden.

Die Anordnung der ersten und zweiten Bauelemente in einem Raster auf der ersten und zweiten Halbleiterscheibe, kann das (Mikro-)Transferdrucken von einer Vielzahl (als Array) von ersten Bauelementen von der ersten Halbleiterscheibe auf die zweite Halbleiterscheibe ermöglichen. In Kombination mit einem auf die Halbleiterscheiben skalierten Stempel kann der Ertrag von zu übertragenden Bauelementen weiter erhöht werden.

Die ersten jeweils individuellen Transferdruckschritte zum Entfernen der nicht-funktionalen ersten Bauelemente können durch einen oder durch mehrere parallel arbeitende Transferdruckstempel zum Entfernen von vereinzelten nicht-funktionalen ersten Bauelementen ausgeführt werden.

Der zweite Transferdruckschritt zum Übertragen der Vielzahl der ersten funktionalen Bauelemente von der ersten Halbleiterscheibe auf die zugehörigen zweiten Bauelemente der zweiten Halbleiterscheibe kann durch einen Transferdruckstempel ausgeführt werden, der auf die erste und/oder zweite Halbleiterscheibe skaliert ist.

Die dritten jeweils individuellen Transferdruckschritte zum Übertragen von einzelnen funktionalen ersten Bauelementen der ersten Halbleiterscheibe auf zweite Bauelemente ohne gedruckte erste Bauelemente können durch einen oder durch mehrere parallel arbeitende Transferdruckstempel zum Übertragen von vereinzelten funktionalen ersten Bauelementen ausgeführt werden.

Durch die Kombination von Einzel-Transferdruckschritten (erste und dritte individuelle Transferdruckschritte) in denen vereinzelte erste nicht-funktionale Bauelemente entfernt bzw. funktionale erste Bauelemente auf unbesetzten Positionen auf den zweiten Bauelementen auf der zweiten Halbleiterscheibe übertragen werden, kann die Ausbeute A auf 100 % angehoben werden. Damit wird die Gesamtausbeute, die sich als Produkt der Ausbeuten A, B und C ergibt, ebenfalls angehoben.

Der zweite Transferdruckschritt umfasst bevorzugt das Übertragen der funktionalen ersten Bauelementen in einem dritten Raster auf die Bauelemente der zweiten Halbleiterscheibe, so dass sich nach dem zweiten Transferdruckschritt auf der zweiten Halbleiterscheibe zweite Bauelemente mit gedrucktem ersten, funktionalen Bauelementen und zweiten Bauelementen noch ohne gedrucktes erstes Bauelement befinden.

Das dritte Raster kann in einer Oberfläche eines Transferstempels integriert sein, der für den zweiten Transferdruckschritt verwendet werden kann. Die Oberfläche kann zum Aufnehmen von den ersten Bauelementen geeignet sein. Bevorzugt ist die Oberfläche so ausgestaltet, dass die ersten Bauelemente adhäsiv an der Oberfläche gehalten werden. Das Raster kann in einer Ebene liegend angeordnet sein. Die Ebene kann deckungsgleich in der Ebene liegen, die durch die Oberfläche des Transferstempels aufgespannt wird. Das Raster kann sich als Netz aus Linien zur Zerlegung der Oberfläche des Transferstempels in eine Vielzahl von Segmenten ergeben, so dass die entstehenden Umrisse den Umrissen der ersten Bauelemente auf der ersten Halbleiterscheibe im Wesentlichen entsprechen.

Das erste, zweite und/oder dritte Raster kann in ihrer Ausbildung ähnlich zueinander sein, so dass zusätzliche Vorbereitungsschritte für den zweiten Transferdruckschritt, bspw. das Anordnen der ersten Bauelemente entsprechend dem zweiten Raster der zweiten Bauelemente auf der zweiten Halbleiterscheibe, wegfallen. Der Transferdruckstempel für den zweiten Transferdruckschritt kann entsprechend dem ersten, zweiten und/oder dritten Raster angepasst sein.

Das Verfahren kann vorteilhaft das Erfassen von nicht-funktionalen ersten Bauelementen auf der ersten Halbleiterscheibe umfassen, bevor diese in den ersten Transferdruckschritten entfernt werden.

Das Erfassen von nicht-funktionalen ersten Bauelementen auf der ersten Halbleiterscheibe kann durch taktile, optische und/oder akustische Verfahren erfolgen. Insbesondere können taktile, optische oder akustische Verfahren angewendet werden, um die Geometrie und/oder die Materialeigenschaften der ersten Bauelemente zu messen bzw. zu erfassen. Die erfassten Daten (Geometrie, Materialeigenschaften etc.) können als Grundlage der Bewertung der Funktionalität der ersten Bauteile dienen.

Nicht-funktionale erste Bauelemente können durch ein optisches Verfahren erfasst werden, insbesondere durch eine automatisierte optische oder elektrische Inspektion oder Messung.

Das optische Verfahren als automatische optische Inspektion (AOI) kann Systeme umfassen, die mittels Bildverarbeitungsverfahren Fehler finden und melden können. Fehler können dazu führen, dass Bauelemente nicht-funktional sind. Fehler können sein: fehlende oder falsche Bauelemente, versetzte Bauelemente und/oder Verunreinigungen der Bauelemente. Bildaufnahmen in dem Bildverarbeitungsverfahren können durch Scanner oder Kameras aufgenommen werden.

Die ersten auf Einzelbauelemente ausgelegten Transferdruckschritte können mehrfach nacheinander erfolgen.

Einzelbauelemente können die ersten nicht-funktionalen Bauelemente sein. Die auf Einzelbauelemente ausgelegten ersten Transferdruckschritte können beinhalten, dass ein einziges nicht-funktionales erstes Bauelement entfernt wird.

Für die ersten, auf Einzelbauelemente ausgelegten Transferdruckschritte kann ein Transferstempel verwendet werden, der so ausgelegt ist, dass der Transferstempel ein einzelnes erstes nicht-funktionales Bauelement aufnimmt.

Durch die Verwendung eines Transferstempels, der auf Einzelbauelemente ausgelegt ist, insbesondere auf die ersten Bauelemente auf der ersten Halbleiterscheibe, kann das Entfernen von (im Vergleich zu den funktionalen Bauelemente wenigen) nicht-funktionalen Bauelemente ermöglicht werden.

Für die ersten, auf Einzelbauelemente ausgelegten Transferdruckschritte können mehrere parallel arbeitende Transferstempel verwendet werden, die so ausgelegt sind, dass sie jeweils ein einzelnes erstes nicht-funktionales Bauelement aufnehmen.

Durch den Einsatz parallel arbeitender Transferstempel zum Entfernen von ersten nicht-funktionalen Bauelementen kann die Ausbeute erhöht werden, wobei gleichzeitig eine Verkürzung der Produktionsdauer erzielt werden kann.

Die erste und die zweite Halbleiterscheibe können denselben Scheibendurchmesser aufweisen.

Die gleiche Dimensionierung der ersten und zweiten Halbleiterscheibe kann das Skalieren des Transferstempels erleichtern, der für den zweiten (eigentlichen) Transferdruckschritt verwendet wird, um die Maximalzahl von Bauelementen, die gleichzeitig gedruckt werden können, zu erhöhen.

Für den zweiten Transferdruckschritt kann ein Transferstempel verwendet werden, der so ausgebildet ist, dass der Transferstempel eine Vielzahl funktionaler Bauelemente auf der ersten Halbleiterscheibe aufnimmt.

Durch das Übertragen einer Vielzahl von funktionalen ersten Bauelementen im zweiten Transferdruckschritt mit dem Transferdruckstempel kann parallel in einem Schritt eine Vielzahl erster und zweiter Bauelemente kombiniert bzw. zweite Bauelemente mit ersten Bauelementen bedruckt werden.

Die dritten auf Einzelbauelemente ausgelegten Transferdruckschritte können mehrfach nacheinander erfolgen.

Einzelbauelemente können die ersten funktionalen Bauelemente sein. Die auf Einzelbauelemente ausgelegten ersten Transferdruckschritte können beinhalten, dass ein einziges funktionales erstes Bauelement übertragen wird.

Für die dritten, auf Einzelbauelemente ausgelegten Transferdruckschritte kann ein Transferstempel verwendet werden, der so ausgelegt ist, dass der Transferstempel ein einzelnes erstes funktionales Bauelement aufnimmt.

Durch die Verwendung eines Transferstempels, der auf Einzelbauelemente ausgelegt ist, insbesondere auf die ersten Bauelemente, kann das Übertragen von funktionalen Bauelementen ermöglicht werden.

Für die dritten, auf Einzelbauelemente ausgelegten Transferdruckschritte können mehrere parallel arbeitende Transferstempel verwendet werden, die so ausgelegt sind, dass sie jeweils ein einzelnes erstes funktionales Bauelement aufnehmen.

Durch den Einsatz parallel arbeitender Transferstempel zum Übertragen von ersten funktionalen Bauelementen auf die zweiten Bauelemente, die noch mit keinem ersten funktionalen Bauelement bedruckt worden sind, kann die Ausbeute erhöht werden, wobei gleichzeitig eine Verkürzung der Produktionsdauer erzielt werden kann.

Alle innerhalb des Verfahrens für die ersten Transferdruckschritte, den zweiten Transferdruckschritt und die dritten Transferdruckschritte verwendeten Transferdruckstempel können Elastomer-Stempel sein, bspw. Stempel aus oder beschichtet mit Polydimethylsiloxan (PDMS). Das Aufnehmen, Übertragen bzw. Entfernen der ersten Bauelemente kann beinhalten, dass der Stempel auf der Oberfläche, auf der sich die ersten Bauelemente befinden, mit den ersten Bauelementen in Kontakt tritt und anschließend die ersten Bauelemente von der Oberfläche der ersten Halbleiterscheibe weg bewegt werden. Durch die Beschleunigung des Stempels, der in Kontakt mit den ersten Bauelementen steht, in Kombination mit der durch die Verwendung eines entsprechenden Elastomers einstellbaren ratenabhängigen (Schälrate) Adhäsion zwischen dem viskoelastischen (Elastomer-)Stempel und den ersten Bauelementen, können die ersten Bauelemente zu einem gewünschten Zielort bewegt werden.

Die ersten und zweiten Bauelemente sind bevorzugt unterschiedlich voneinander, insbesondere unterschiedlich in der Materialart, in der Kristallorientierung, in der Geometrie und/oder in der Dicke.

Die ersten Bauelemente auf der ersten Halbleiterscheibe können GaN-Bauelemente und die zweiten Bauelemente auf der zweiten Halbleiterscheibe können CMOS-Schaltkreise sein.

Die ersten Bauelemente auf der ersten Halbleiterscheibe können auch bevorzugt LEDs, Hallsensoren, optische Filter oder MEMS-Elemente sein.

Die ersten Bauelemente auf der ersten Halbleiterscheibe können CMOS-Schaltkreise und die zweiten Bauelemente auf der zweiten Halbleiterscheibe können weiter bevorzugt GaN-Bauelemente sein.

Die erste Halbleiterscheibe und die zweite Halbleiterscheibe können unterschiedlich voneinander sein, insbesondere unterschiedlich in der Materialart, in der Kristallorientierung, in dem Scheibendurchmesser und/oder in der Scheibendicke.

Nach dem Übertragen von einzelnen funktionalen ersten Bauelementen auf die zweiten Bauelemente ohne gedruckte erste Bauelemente in dritten jeweils individuellen Transferdruckschritten kann das Abscheiden von zumindest einer Isolator-Schicht und/oder zumindest einer leitfähigen Schicht auf der zweiten Halbleiterscheibe erfolgen. Das Verfahren kann das Strukturieren von der zumindest einen Isolator-Schicht und/oder der zumindest einen leitfähigen Schicht auf der zweiten Halbleiterscheibe umfassen.

Die ersten Bauelemente auf der ersten Halbleiterscheibe können vor den ersten Transferdruckschritten lateral von Anbinde-Elementen gehalten sein (sog. Tether), insbesondere nach einem Freiätzen der ersten Bauelemente aus der ersten Halbleiterscheibe vor dem Bereitstellen.

Die Anbinde-Elemente halten die ersten Bauelemente auf der ersten Halbleiterscheibe räumlich stabil. Die Anbinde-Elemente können so konzipiert sein, dass sie bei den ersten Transferdruckschritten bzw. bei dem zweiten Transferdruckschritt in kontrollierter Weise brechen oder spalten. Neben Anbinde-Elementen (als Sollbruchstellen) können auch andere Freigabe-Strategien angewendet werden (engl. sacrificial release strategies).

Die Ausführungsformen der Erfindung sind anhand von Beispielen dargestellt, jedoch nicht auf eine Weise, in der Beschränkungen aus den Figuren in die Patentansprüche übertragen oder hineingelesen werden. Gleiche Bezugszeichen in den Figuren geben gleiche Elemente an.
- Fig. 1: zeigt ein Flussdiagramm eines Verfahrens 100 zur Herstellung von Halbleiterbauelementen mit einer Ausbeutesteigerung beim Mikrotransferdruck;
- Fig. 2: zeigt ein Flussdiagramm als weitere Ausführungsform eines Verfahrens 200 zur Herstellung von Halbleiterbauelementen mit einer Ausbeutesteigerung beim Mikrotransferdruck;
- Fig. 3: zeigt eine erste Halbleiterscheibe 300 mit ersten funktionalen 304 und nichtfunktionalen 302 Bauelementen vor ersten Mikrotransferdruckschritten;
- Fig. 4: zeigt eine zweite Halbleiterscheibe 400 mit zweiten Bauelementen 402 vor einem zweiten Mikrotransferdruckschritt;
- Fig. 5: zeigt die erste Hableiterscheibe 300 mit ausschließlich ersten funktionalen Bauelementen 302 nach den ersten Mikrotransferdruckschritten;
- Fig. 6: zeigt die zweite Halbleiterscheibe 400 mit bedruckten Bauelementen 404 und unbedruckten zweiten Bauelementen 408 nach dem zweiten Mikrotransferdruckschritt;
- Fig. 7: zeigt die zweite Halbleiterscheibe 400 mit ausschließlich bedruckten Bauelementen 404 nach dritten Mikrotransferdruckschritten.

Die Figurenbeschreibung der Figuren 3 und 4 werden vorgezogen, damit die Ausführungen zu dem in Flussdiagramm 1 (bzw. Flussdiagramm 2) dargestellten Verfahren besser nachvollzogen werden können.

Fig. 3 zeigt eine erste Halbleiterscheibe 300 mit ersten funktionalen 304 und nicht-funktionalen 302 Bauelementen vor ersten Mikrotransferdruckschritten.

Die erste Halbleiterscheibe 300 weist eine im Wesentlichen kreisförmige Grundform auf. Die erste Halbleiterscheibe 300 weist einen Bereich mit reduziertem radialen Durchmesser 300' auf. Auf der ersten Halbleiterscheibe 300 ist eine Vielzahl erster funktionaler Bauelemente 304, 304', 304" ... 304* und erster nicht-funktionaler Bauelemente 302, 302', 302"... 302* angeordnet. Nicht-funktionale Bauelemente 302 sind mit einem X markiert. Die Koordinaten auf der ersten Halbleiterscheibe 300 sind durch ein in der Ebene der ersten Halbleiterscheibe 300 liegendes x,y-Koordinatensystem eindeutig definiert. Die ersten Bauelemente 302, 304 sind in einem Raster in der Ebene der ersten Halbleiterscheibe 300 liegend angeordnet (x,y-Ebene).

Die erste Halbleiterscheibe 300 kann eine quadratische Scheibe sein.

Die erste Halbleiterscheibe 300 kann aus ein- oder polykristallinen Materialien gefertigt sein.

Die erste Halbleiterscheibe 300 kann so ausgestaltet sein, dass sie als Substrat (Grundplatte) für elektronische Bauelemente dient, bevorzugt integrierten Schaltkreisen, mikromechanischen Bauelementen oder photoelektrischen Beschichtungen als erste Bauelemente von denen die Bauelemente 302 Schäden aufweisen oder schadhaft sind, so dass ihre bestimmungsgemäße Funktion nicht gegeben ist, diese also nicht-funktional sind.

Nach der eigentlichen Herstellung könnte davon ausgegangen werden, dass alle ersten Bauelemente intakte (funktionale) Bauelemente 304 sind, aber in der Realität kann es vorkommen, dass einige von den ersten Bauelementen schadhaft sind. Diese schadhaften (nicht-funktionalen) Bauelemente werden 302 genannt, wären aber bestmöglich auch funktionale Bauelemente 304.

Die erste Halbleiterscheibe 300 kann eine Dicke zwischen 0,275 bis 0,925 mm aufweisen, bevorzugt eine Dicke von 1,0 mm haben.

Der Durchmesser der ersten Halbleiterscheibe 300 kann zwischen 50,0 mm und 450,0 mm liegen, bevorzugt einen Durchmesser 100,0 bis 300,0 mm betragen.

Die erste Halbleiterscheibe 300 kann aus monokristallinem Silizium, Siliciumcarbid, Gallium-Arsenid oder Indiumphosphid bestehen.

Der Bereich mit einseitig reduziertem Durchmesser 300' kann eine gerade Kante an einer Seite der ersten Halbleiterscheibe 300 sein (sog. Flat).

Der Bereich mit einseitig reduziertem Durchmesser 300' kann eine seitliche Einkerbung in einer Seite der ersten Halbleiterscheibe 300 sein (sog. Notch).

Der Bereich mit einseitig reduziertem Durchmesser 300' kann so ausgebildet sein, dass er die Kristallorientierung der ersten Halbleiterscheibe 300 indiziert.

Der Bereich mit einseitig reduziertem Durchmesser 300' kann so ausgebildet sein, dass er zur genauen Positionierung der ersten Halbleiterscheibe 300 in einer Produktionsanlage für Halbleiter verwendet werden kann.

Der Bereich mit einseitig reduziertem Durchmesser 300' kann mehrere Bereiche mit einseitig reduziertem Durchmesser umfassen.

Nachdem die Bauelemente 302, 304 auf der Trägerscheibe 300 hergestellt worden sind, ergeben sich auch solche Bauelemente 302, die schadhaft sind, also ihre Funktion nicht erfüllen könnten. Sie werden nicht-funktional genannt.

Die ersten Bauelemente (erste funktionale 304 und erste nicht-funktionale 302 Bauelemente auf der ersten Halbleiterscheibe 300) können integrierte Schaltkreise oder mikromechanische Bauelemente sein.

Die ersten Bauelemente können eine im Wesentlichen rechteckige Grundform aufweisen.

Funktionale erste Bauelemente 304 sind solche, die ihrem funktionalen Gebrauch dienen können. Als Umkehrschluss ergibt sich, dass nicht-funktionale Bauelemente 302 Bauelemente sind, die nicht ihrem zugedachten funktionalen Gebrauch dienen können.

Die Vielzahl von ersten funktionalen Bauelementen 304, 304' ... 300* wird deutlich größer sein als die Anzahl von ersten nicht-funktionalen Bauelementen 302, 302' ... 302*.

Das Raster kann sich als Netz aus Linien zur Zerlegung der Oberfläche der ersten Halbleiterscheibe 300 in eine Vielzahl von Segmenten ergeben, so dass Umrisse der ersten Bauelemente auf der ersten Halbleiterscheibe 300 definiert werden.

Die ersten Bauelemente können lateral beabstandet in gleichmäßiger Anordnung, vorzugsweise in einem Raster, auf der ersten Halbleiterscheibe 300 angeordnet sein.

Die ersten Bauelemente können lateral von Anbinde-Elementen (nicht dargestellt) gehalten sein (sog. Tether). Die Anbinde-Elemente können alle ersten Bauelemente so auf der ersten Halbleiterscheibe 300 anbinden, dass sie räumlich auch dann stabil gehalten werden, wenn sie freigeätzt sind.

Die Anbinde-Elemente sind so konzipiert, dass sie bei Krafteinwirkung kontrolliert brechen. Ihre Reste nach einem Brechen sind an den ersten Bauelementen zu erkennen, aber hier nicht dargestellt.

Fig. 4 zeigt eine zweite Halbleiterscheibe 400 mit zweiten Bauelementen 402 vor einem zweiten Mikrotransferdruckschritt. Diese Bauelemente sind andere Bauelemente als die ersten Bauelemente.

Auch die zweite Halbleiterscheibe 400 weist eine im Wesentlichen kreisförmige Form auf. Die zweite Halbleiterscheibe 400 weist einen Bereich mit reduziertem radialen Durchmesser 400' auf. Auf der zweiten Halbleiterscheibe 400 ist eine Vielzahl von Bauelementen 402, 402', 402" ... 402* angeordnet. Die Koordinaten auf der zweiten Halbleiterscheibe 400 sind durch ein in der Ebene der zweiten Halbleiterscheibe 400 liegendes x',y'-Koordinatensystem eindeutig definiert. Die zweiten Bauelemente 402 sind in einem Raster in der Ebene der zweiten Halbleiterscheibe 400 liegend angeordnet (x',y'-Ebene).

Die zweite Halbleiterscheibe 400 kann wie die erste Halbleiterscheibe 300 eine kreisrunde oder quadratische Scheibe sein, eine Dicke zwischen 0,275 bis 0,925 mm und einen Durchmesser zwischen 50,0 mm und 450,0 mm aufweisen.

Bevorzugt weist die zweite Halbleiterscheibe 400 eine Dicke von 1.0 mm und einen Durchmesser von 100,0 bis 300,0 mm auf.

Die zweite Halbleiterscheibe 400 kann ebenfalls aus ein- oder polykristallinen Materialien gefertigt sein, vorzugsweise ist die zweite Halbleiterscheibe aus monokristallinem Silizium, Siliciumcarbid, Gallium-Arsenid oder Indiumphosphid gefertigt.

Die zweite Halbleiterscheibe 400 kann so ausgestaltet sein, dass sie als Substrat (Grundplatte) für elektronische Bauelemente dient, bevorzugt integrierten Schaltkreisen, mikromechanischen Bauelementen oder photoelektrischen Beschichtungen.

Der Bereich mit einseitig reduziertem Durchmesser 400' kann ähnlich zu dem einseitig reduziertem Bereich 300' der ersten Halbleiterscheibe 300 ausgebildet sein. Der Bereich 400' kann eine gerade Kante an einer Seite der zweiten Halbleiterscheibe 400 sein (sog. Flat) oder (alternativ) kann der Bereich mit einseitig reduziertem Durchmesser 400' eine seitliche Einkerbung in einer Seite der zweiten Halbleiterscheibe sein 400 (sog. Notch).

Der Bereich mit einseitig reduziertem Durchmesser 400' kann ebenfalls so ausgebildet sein, dass er die Kristallorientierung der zweiten Halbleiterscheibe 400 indiziert.

Der Bereich mit einseitig reduziertem Durchmesser 400' kann zudem so ausgebildet sein, dass er zur genauen Positionierung der zweiten Halbleiterscheibe 400 in einer Produktionsanlage für Halbleiter verwendet werden kann.

Der Bereich mit einseitig reduziertem Durchmesser 400' kann mehrere Bereiche mit einseitig reduziertem Durchmesser umfassen, z.B. jeweils ein Bereich zur exakten Ausrichtung und ein Bereich zur Indizierung des Scheibentyps (Kristallorientierung, p-/n-Dotierung).

Die Vielzahl von zweiten Bauelementen 402, 402' ... 402* umfasst im Beispiel funktionale Bauelemente. Bei der Herstellung mit etablierten (gut bekannten) Verfahren wird eine sehr hohe Ausbeute erzielt, so dass keine (oder so gut wie keine) schadhaften Bauelemente vorhanden sind.

Die zweiten Bauelemente 402 können integrierte Schaltkreise oder mikromechanische Bauelemente sein.

Die zweiten Bauelemente 402 haben im gezeigten Beispiel eine im Wesentlichen rechteckige Form.

Die ersten 302, 304 und zweiten Bauelemente 402 sind bevorzugt unterschiedlich voneinander, insbesondere unterschiedlich in der Materialart, in der Kristallorientierung, in der Geometrie und/oder in der Dicke.

Das Raster kann sich als Netz aus Linien zur Zerlegung der Oberfläche der zweiten Halbleiterscheibe 400 in eine Vielzahl von Segmenten ergeben, so dass Umrisse der zweiten Bauelemente 402 auf der zweiten Halbleiterscheibe definiert werden.

Die zweiten Bauelemente 402 können lateral beabstandet in gleichmäßiger Anordnung, vorzugsweise in einem Raster, auf der zweiten Halbleiterscheibe 400 angeordnet sein.

Die erste 300 und die zweite 400 Halbleiterscheibe können denselben Scheibendurchmesser aufweisen.

Die ersten Bauelemente 302, 304 auf der ersten Halbleiterscheibe 300 sind bevorzugt GaN-Bauelemente und die zweiten Bauelemente 402 auf der zweiten Halbleiterscheibe 400 ebenso bevorzugt CMOS-Schaltkreise.

Die ersten Bauelemente 302, 304 auf der ersten Halbleiterscheibe 300 können auch LEDs, Hallsensoren, optische Filter oder MEMS-Elemente sein.

Die ersten Bauelemente 302, 304 auf der ersten Halbleiterscheibe 300 können CMOS-Schaltkreise und die zweiten Bauelemente 402 auf der zweiten Halbleiterscheibe 400 können weiter bevorzugt GaN-Bauelemente sein.

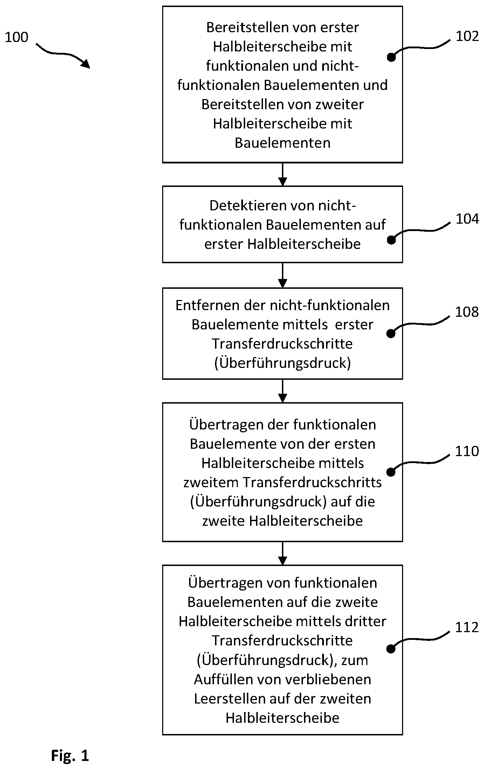

Fig. 1 zeigt ein Flussdiagramm eines ersten Verfahrens 100 zur Herstellung von Halbleiterbauelementen.

In Verfahrensschritt 102 werden eine Halbleiterscheibe mit funktionalen Bauelementen und eine zweite Halbleiterscheibe mit funktionalen Bauelementen bereitgestellt. Unter den ersten Bauelementen sind aber auch solche, die einen Schaden haben. Sie entstehen bei der Fertigung und werden in diesem Sinne 'bereitgestellt', obwohl eine Herstellung von ausschließlich Gut-Bauelementen beabsichtigt würde. Bei den zweiten Bauelementen wird angenommen, dass ausschließlich Gut-Bauteile entstehen bzw. eine sehr hohe Ausbeute (nahe 100 %) erzielt wird.

Bei der Halbleiterscheibe mit funktionalen und nicht-funktionalen Bauelementen kann es sich um eine erste Halbleiterscheibe 300 mit funktionalen 304 und nicht-funktionalen Bauelementen 302 wie mit Blick auf Fig. 3 beschrieben und bei der zweiten Halbleiterscheibe um eine zweite Halbleiterscheibe 400 mit Bauelementen 402 nach Fig. 4 handeln. Insbesondere kann es sich bei der ersten Halbleiterscheibe 300 um eine Halbleiterscheibe mit freigestellten ersten Bauelementen handeln.

Das Bereitstellen der ersten 300 und zweiten 400 Halbleiterscheibe kann umfassen, dass von einer Produktionsanlage zur Herstellung von Halbleiterbauelementen die Halbleiterscheiben 300, 400 bereitgestellt werden. Das Bereitstellen kann hierbei so erfolgen, dass die Produktionsanlage weitere Verfahrensschritte mit bzw. auf der ersten 300 und/oder der zweiten 400 Halbleiterscheibe durchführen kann. Die einzelnen Verfahrensschritte werden hier nicht dargestellt.

In einem weiteren Schritt 104 werden die nicht-funktionalen Bauelemente 302 auf der ersten Halbleiterscheibe 300 detektiert. Das Detektieren von nicht-funktionalen ersten Bauelementen 302 auf der ersten Halbleiterscheibe 300 kann durch taktile, optische und/oder akustische Verfahren erfolgen. Insbesondere können taktile, optische oder akustische Verfahren angewendet werden, um die Geometrie und/oder die Materialeigenschaften der ersten Bauelemente zu messen bzw. zu erfassen.

Die erfassten Daten (Geometrie, Materialeigenschaften etc.) können als Grundlage der Bewertung der Funktionalität der ersten Bauteile dienen, ob sie also als 302-Bauelemente (nicht-funktional) oder 304-Bauelemente (funktional) zu klassifizieren sind.

Messinstrumente, insbesondere für taktile, optische und/oder akustische Messverfahren, können in der Produktionsanlage integriert sein. Vorzugsweise kann es sich um optische Messverfahren und korrespondierende Messinstrumente handeln.

Optische Verfahren können als Automatisches Optisches Inspektions (AOI)-System implementiert sein, das mittels Bildverarbeitungsverfahren Fehler am Bauelement (in den ersten Bauelementen) finden und melden kann. Fehler können dazu führen, dass Bauelemente als nicht-funktional gekennzeichnet werden und ihre x,y-Position gespeichert wird. Diese sind dann nicht-funktionale 302-Bauteile. Fehler können sein: fehlende oder falsche Bauelemente, versetzte Bauelemente und/oder Verunreinigungen der Bauelemente. Bildaufnahmen in dem Bildverarbeitungsverfahren (AOI) können durch Scanner oder Kameras aufgenommen werden.

In Schritt 108 werden die als nicht-funktional identifizierten Bauelemente 302 mittels erster jeweils individueller Transferdruckschritte von der ersten Halbleiterscheibe 300 entfernt. Es verbleiben nur Gut-Bauelemente 304 auf der Scheibe 300.

Nachfolgend wird zum besseren Verständnis zunächst auf Figur 5 eingegangen, damit die Verfahrensschritte 110 und 112 besser nachvollzogen werden können.

Fig. 5 zeigt die erste Hableiterscheibe 300 mit ausschließlich ersten funktionalen Bauelementen 302 nach den ersten Mikrotransferdrucken. Die erste Halbleiterscheibe 300 weist neben den funktionalen ersten Bauelementen 304 eine Vielzahl unbesetzter Positionen 308, 308', 308" ... 308* auf, die den Positionen der vormals auf der ersten Halbleiterscheibe 300 befindlichen nicht-funktionalen Bauelemente 302 entsprechen.

Die ersten jeweils individuellen Transferdruckschritte zum Entfernen der nicht-funktionalen Bauelemente 302 können durch einen oder durch mehrere parallel arbeitende Transferdruckstempel zum Entfernen von vereinzelten nicht-funktionalen ersten Bauelementen 302 ausgeführt werden.

Die ersten auf Einzelbauelemente ausgelegten Transferdruckschritte können hierbei mehrfach nacheinander erfolgen.

Für die ersten, auf Einzelbauelemente ausgelegten Transferdruckschritte kann ein Transferstempel verwendet werden, der so ausgelegt ist, dass der Transferstempel ein einzelnes erstes nicht-funktionales Bauelement 302 aufnimmt (und von der Scheibe entfernt).

Für die ersten, auf Einzelbauelemente ausgelegten Transferdruckschritte können mehrere parallel arbeitende Transferstempel verwendet werden, die so ausgelegt sind, dass sie jeweils ein einzelnes nicht mehr funktionales Bauelement 302 aufnehmen (und entfernen).

In Schritt 110 werden die ersten funktionalen Bauelemente 304 in einem zweiten Transferdruckschritt auf die zweite Halbleiterscheibe 400 übertragen.

Für den zweiten Transferdruckschritt wird im Beispiel ein Transferdruckstempel verwendet, der so ausgebildet ist, dass der Transferdruckstempel eine Vielzahl funktionaler Bauelemente 304 auf der ersten Halbleiterscheibe 300 gleichzeitig aufnimmt und auf die zweite Scheibe und deren Bauelemente überträgt.

Der Transferstempel, der für den zweiten Transferdruckschritt verwendet wird, kann so ausgestaltet sein, dass die funktionalen Bauelemente 304 so in einem Raster des Stempels aufgenommen werden, dass sie dem Raster, in dem die zweiten Bauelemente 402 auf der zweiten Halbleiterscheibe angeordnet sind, entsprechen.

Die ersten funktionalen Bauelemente 304 werden mittels des Transferdruckstempels von der ersten Halbleiterscheibe 300 auf die zweiten Bauelemente 402 der zweiten Halbleiterscheibe 400 innerhalb des zweiten Transferdruckschritts übertragen.

Der Transferstempel, der für den zweiten Transferdruckschritt verwendet wird, kann auf die zweite Halbleiterscheibe 400 skaliert sein. Mit dem skalierten Stempel können mehrfach hintereinander von der ersten Halbleiterscheibe 300 funktionale Bauelemente 304 auf Bauelemente 402 mehrerer Halbleiterscheiben 400 übertragen werden. Bei dem zweiten Transferdruck werden bei dem mehrfach hintereinander ausgeführten zweiten Transferdruckschritt jeweils um eine Position versetzt Bauelemente 304 von der ersten Halbleiterscheibe 300 aufgenommen. In diesem Beispiel befindet sich ein Vielfaches an ersten Bauelementen auf der ersten Halbleiterscheibe, mit Bezug auf die Anzahl der Bauelemente auf der zweiten Halbleiterscheibe.

Durch das Entfernen der nicht-funktionalen Bauelemente 302 auf der ersten Halbleiterscheibe 300 kann es sich ergeben, dass der Transferdruckstempel, der für den zweiten Transferdruckschritt verwendet wird, nach dem Aufnehmen der funktionalen Bauelemente 304 unbesetzte Positionen aufweist, weil kein funktionales Bauelement 304 an der entsprechenden Position 308 vorhanden gewesen ist, so dass sich nach dem zweiten Transferdruckschritt auf der zweiten Halbleiterscheibe 400 zweite Bauelemente mit gedruckten funktionalen Bauelementen und zweite Bauelemente noch ohne gedruckte Bauelemente befinden.

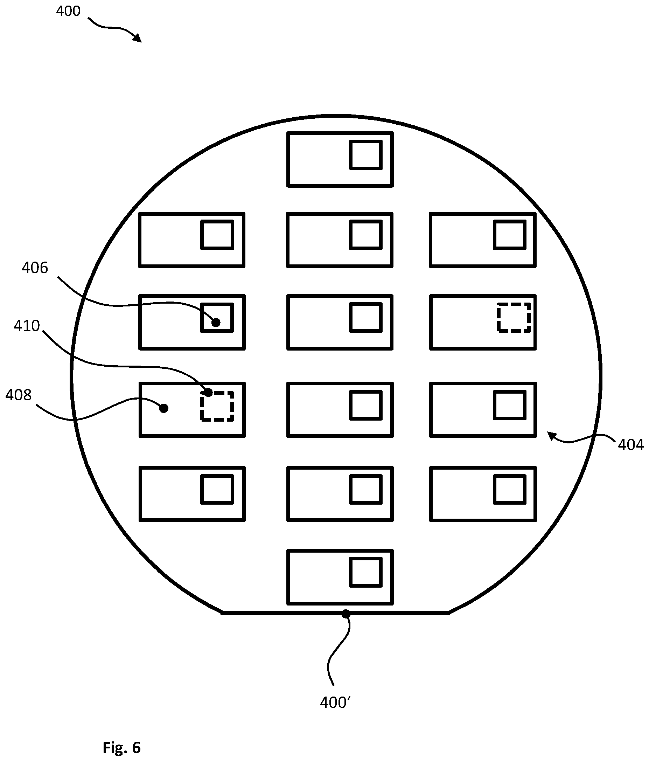

Dies wird in Fig. 6 veranschaulicht. Fig. 6 zeigt die zweite Halbleiterscheibe 400 mit bedruckten Bauelementen (dritte Bauelemente) 404 und unbedruckten zweiten Bauelementen 408 nach dem zweiten Mikrotransferdruckschritt. Diese haben derzeit noch nicht deren beabsichtigte Funktion.

Die dritten Bauelemente 404 umfassen erste gedruckte funktionale Bauelemente 406 (zuvor 304) und zweite Bauelemente 408 (zuvor 402). Die zweiten unbedruckten Bauelemente 408 weisen unbesetzte Positionen 410 auf.

In Schritt 112 werden funktionale Bauelemente 302 auf die zweite Halbleiterscheibe 400 in dritten jeweils individuellen Transferdruckschritten auf die Leerstellen (unbesetzten Positionen) 410 auf den zweiten Bauelementen 408 der zweiten Halbleiterscheibe 400 übertragen.

Die dritten auf Einzelbauelemente ausgelegten Transferdruckschritte können mehrfach nacheinander erfolgen.

Für die dritten, auf Einzelbauelemente ausgelegten Transferdruckschritte kann ein Transferstempel verwendet werden, der so ausgelegt ist, dass der Transferstempel ein einzelnes erstes funktionales Bauelement 304 aufnimmt, das nach seinem Transferdruck auf das zweite Bauelement 408 dort 406 heißt und ein funktionell vervollständigtes Bauelemente 404 auf der zweiten Scheibe bildet.

Für die dritten, auf Einzelbauelemente ausgelegten Transferdruckschritte können mehrere parallel arbeitende Transferstempel verwendet werden, die so ausgelegt sind, dass sie jeweils ein einzelnes erstes funktionales Bauelement 304 aufnehmen.

Der Transferdruckstempel (oder die Transferdruckstempel) für die ersten Transferdruckschritte, der Transferdruckstempel für den zweiten Transferdruckschritt und/oder der Transferdruckstempel (oder die Transferdruckstempel) für die dritten Transferdruckstempel können in der Produktionsanlage integriert sein.

Alle innerhalb des Verfahrens verwendeten Transferdruckstempel können Elastomer-Stempel sein, bspw. Stempel aus oder beschichtet mit Polydimethylsiloxan (PDMS).

Das Übertragen bzw. Entfernen der ersten Bauelemente kann beinhalten, dass die Stempel auf der Oberfläche zunächst mit den Bauelementen im jeweiligen Transferdruckschritt in Kontakt treten und anschließend die ersten Bauelemente von der Oberfläche der ersten Halbleiterscheibe 300 weg bewegt werden bzw. zur Oberfläche der zweiten Halbleiterscheibe 400 hin bewegt werden.

Durch die Beschleunigung des jeweiligen Stempels, der in Eingriff mit den ersten Bauelementen 304 bzw. dem ersten Bauelement 302, 304 steht, in Kombination mit der durch die Verwendung eines entsprechenden Elastomers einstellbaren ratenabhängigen (Schälrate) Adhäsion zwischen dem viskoelastischen (Elastomer-)Stempel und den ersten Bauelementen 302, 304, können die ersten Bauelemente zu einem gewünschten Zielort bewegt werden.

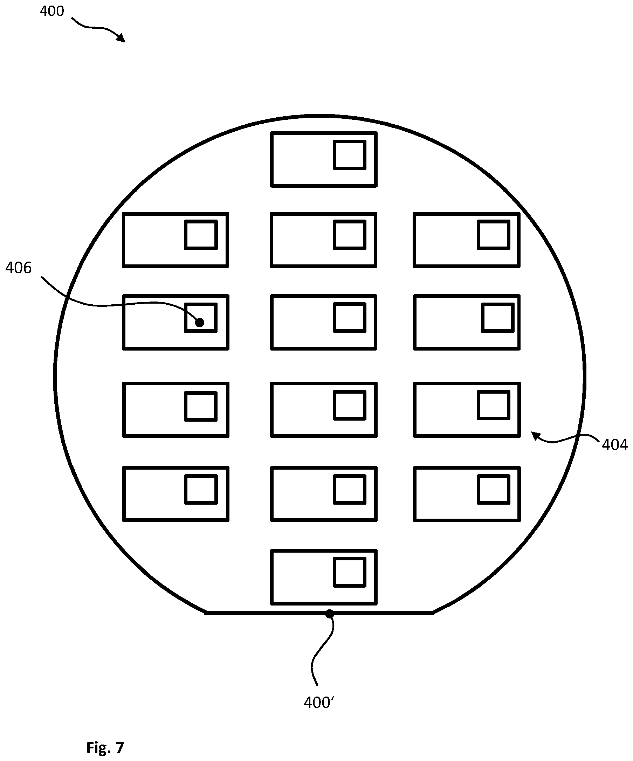

Nach den dritten Transferdruckschritten sind alle unbesetzten Positionen 410 mit funktionalen ersten Bauelementen 304 besetzt, so dass sich ausschließlich dritte Bauelemente 404 auf der zweiten Halbleiterscheibe 400 befinden, die vollständig funktionsfähig sind. Dies wird in Figur 7 veranschaulicht.

Nach dem Übertragen von einzelnen funktionalen Bauelementen 304 auf die zweiten Bauelemente 408 (ohne gedruckte Bauelemente 304 als 406) in dritten jeweils individuellen Transferdruckschritten, können weitere Verfahrensschritte mit bzw. auf der zweiten Halbleiterscheibe 400 durchgeführt werden.

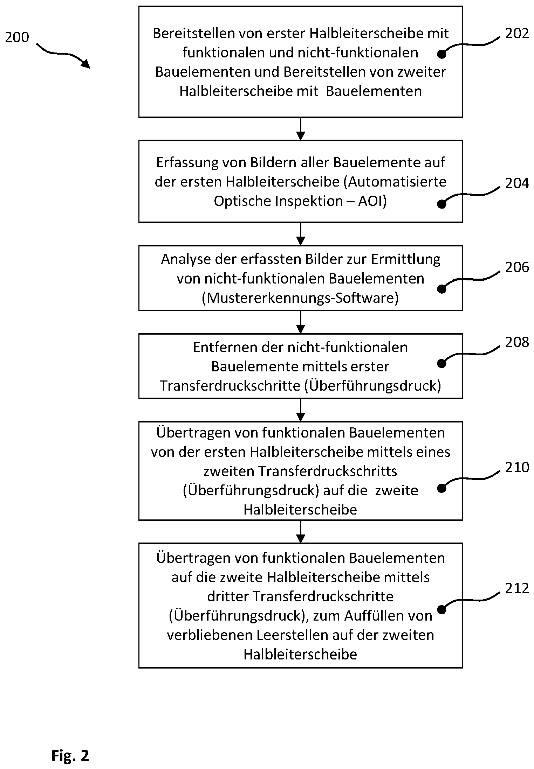

Nach dem Übertragen von einzelnen funktionalen Bauelementen 304 auf die zweiten Bauelemente 408 (ohne gedruckte Bauelemente 304 als 406) in dritten jeweils individuellen Transferdruckschritten, kann das Abscheiden von zumindest einer Isolator-Schicht und/oder zumindest einer leitfähigen Schicht auf der zweiten Halbleiterscheibe 400 erfolgen. Das Verfahren kann weiterhin das Strukturieren von der zumindest einen Isolator-Schicht und/oder der zumindest einen leitfähigen Schicht auf der zweiten Halbleiterscheibe umfassen.Fig. 2 zeigt ein Flussdiagramm einer weiteren Ausführungsform eines Verfahrens 200 zur Herstellung von Halbleiterbauelementen im Mikrotransferdruck.

In Verfahrensschritt 202 wird eine Halbleiterscheibe mit scheinbar (sichtmäßig) nur funktionalen Bauelementen bereitgestellt. Ebenso wird eine zweite Halbleiterscheibe mit Bauelementen bereitgestellt, die im Beispiel alle funktionstauglich sind.

Bei der Halbleiterscheibe mit funktionalen und nicht-funktionalen Bauelementen kann es sich um eine erste Halbleiterscheibe 300 mit funktionalen 304 und nicht-funktionalen Bauelementen 302 wie mit Blick auf Fig. 3 beschrieben und bei der zweiten Halbleiterscheibe um eine zweite Halbleiterscheibe 400 mit Bauelementen 402 nach Fig. 4 handeln. Insbesondere kann es sich bei der ersten Halbleiterscheibe 300 um eine nach einem Freiätzen der ersten Bauelemente 302, 304 bereitgestellten Halbleiterscheibe handeln.

Das Bereitstellen der ersten 300 und zweiten 400 Halbleiterscheibe kann umfassen, dass einer Produktionsanlage zur Herstellung von Halbleiterbauelementen die Halbleiterscheiben 300, 400 bereitgestellt werden. Das Bereitstellen kann hierbei so erfolgen, dass die Produktionsanlage weitere Verfahrensschritte mit bzw. auf der ersten 300 und/oder der zweiten 400 Halbleiterscheibe durchführen kann.

In Schritt 204 werden Bilder aller Bauelemente 302, 304 auf der ersten Halbleiterscheibe 300 zur Beurteilung der Funktionsfähigkeit der ersten Bauelemente 302, 304 in einer Automatischen Optischen Inspektion (AOI) erfasst.

Die entsprechenden Messinstrumente/Aufnahmegeräte für die AOI können in der Produktionsanlage integriert sein. Die Aufnahmegeräte können Scanner oder Kameras sein.

In Schritt 206 werden die erfassten Bilder zur Ermittlung von nicht-funktionalen ersten Bauelementen 302 analysiert.

Die Analyse kann insbesondere Fehler an oder in den ersten Bauelementen aufdecken. Fehler können dazu führen, dass Bauelemente nicht-funktional sind. Fehler können sein: fehlende oder falsche Bauelemente, versetzte Bauelemente und/oder Verunreinigungen der Bauelemente.

Das sich in den Verfahrensschritten 208 bis 212 anschließende dreistufige Transferdruckverfahren entspricht im Wesentlichen den Verfahrensschritten 108 bis 112 des in Figur 1 im Flussdiagramm dargestellten Verfahren.

Die Verfahrensschritte 208 bis 212 können identisch zu den Verfahrensschritten 108 bis 112 sein und den damit verbundenen vorherig beschriebenen Ausführungsmöglichkeiten.

## Patentansprüche

1. **Verfahren zur Herstellung** von Halbleiterbauelementen, das Verfahren mit den folgenden Schritten
(a') Bereitstellen (102) einer ersten Halbleiterscheibe (300) mit ersten überwiegend funktionalen Bauelementen (304) und wenigen ersten nicht-funktionalen Bauelementen (302) in einem ersten Raster (x,y), wobei die ersten Bauelemente (302,304) auf der ersten Halbleiterscheibe (300) lateral von Anbinde-Elementen gehalten werden;
(b') Bereitstellen (102) einer zweiten Halbleiterscheibe (400) mit zweiten Bauelementen (402) in einem zweiten Raster (x',y');
(a) Entfernen (108) der nicht-funktionalen ersten Bauelemente (302) von der ersten Halbleiterscheibe (300) in ersten jeweils individuellen Transferdruckschritten;
(b) Übertragen (110) einer Vielzahl der ersten funktionalen Bauelemente (304) von der ersten Halbleiterscheibe (300) auf die zugehörigen zweiten Bauelemente (402) der zweiten Halbleiterscheibe (400) in einem zweiten Transferdruckschritt;
(c) Übertragen (112) von einzelnen funktionalen ersten Bauelementen (304) der ersten Halbleiterscheibe (300) auf zweite Bauelemente (408) ohne gedruckte erste Bauelemente in dritten jeweils individuellen Transferdruckschritten;
(a") Abscheiden von zumindest einer Isolator-Schicht und/oder zumindest einer leitfähigen Schicht auf der zweiten Halbleiterscheibe;
(b") Strukturieren von der zumindest einen Isolator-Schicht und/oder der zumindest einen leitfähigen Schicht auf der zweiten Halbleiterscheibe.

2. Verfahren nach Anspruch 1, wobei bei dem zweiten Transferdruckschritt die funktionalen ersten Bauelemente (304) in einem dritten Raster auf die Bauelemente (402) der zweiten Halbleiterscheibe (400) übertragen werden, so dass sich nach dem zweiten Transferdruckschritt auf der zweiten Halbleiterscheibe (400) zweite Bauelemente mit gedrucktem ersten, funktionalen Bauelement (404) und zweite Bauelemente (408) noch ohne ein gedrucktes erstes Bauelement befinden.

3. Verfahren nach Anspruch 1 oder 2, wobei das Verfahren weiterhin umfasst:
(c') Erfassen (104) von nicht-funktionalen ersten Bauelementen (302) auf der ersten Halbleiterscheibe (300), bevor diese in den ersten Transferdruckschritten entfernt werden.

4. Verfahren nach Anspruch 3, wobei nicht-funktionale erste Bauelemente (302) durch ein optisches oder elektrisches Verfahren erfasst werden, insbesondere durch eine automatische optische oder elektrische Inspektion oder Messung.

5. Verfahren nach einem der vorangegangenen Ansprüche, wobei die ersten Transferdruckschritte mehrere auf Einzelbauelemente (302) ausgelegte Transferdruckschritte sind.

6. Verfahren nach Anspruch 1 oder 5, wobei für die ersten, auf Einzelbauelemente ausgelegten Transferdruckschritte ein Transferstempel verwendet wird, der so ausgelegt ist, dass der Transferstempel ein einzelnes erstes nicht-funktionales Bauelement (302) aufnimmt.

7. Verfahren nach einem der Ansprüche 1 bis 4, wobei für die ersten, auf Einzelbauelemente ausgelegte Transferdruckschritte mehrere parallel arbeitende Transferstempel verwendet werden, die so ausgelegt sind, dass sie jeweils ein einzelnes erstes nicht-funktionales Bauelement (302) aufnehmen.

8. Verfahren nach einem der vorangegangenen Ansprüche, wobei die erste Halbleiterscheibe (300) und die zweite Halbleiterscheibe (400) denselben Scheibendurchmesser aufweisen.

9. Verfahren nach einem der vorangegangenen Ansprüche, wobei für den zweiten Transferdruckschritt ein Transferstempel verwendet wird, der so ausgebildet ist, dass der Transferstempel eine Vielzahl erster funktionaler Bauelemente (304) auf der ersten Halbleiterscheibe (300) aufnimmt.

10. Verfahren nach einem der vorangegangenen Ansprüche, wobei die dritten Transferdruckschritte auf Einzelbauelemente (304) ausgelegte Transferdruckschritte sind.

11. Verfahren nach einem der vorangegangenen Ansprüche, wobei für die dritten, auf Einzelbauelemente ausgelegten Transferdruckschritte ein Transferstempel verwendet wird, der so ausgelegt ist, dass der Transferstempel ein einzelnes erstes funktionales Bauelement (304) aufnimmt.

12. Verfahren nach einem der vorangegangenen Ansprüche, wobei für die dritten, auf Einzelbauelemente ausgelegten Transferdruckschritte mehrere parallel arbeitende Transferstempel verwendet werden, die so ausgelegt sind, dass sie jeweils ein einzelnes erstes funktionales Bauelement (304) aufnehmen.

13. Verfahren nach einem der vorangegangenen Ansprüche, wobei die ersten Bauelemente (302, 304) auf der ersten Halbleiterscheibe (300) GaN-Bauelemente und die zweiten Bauelemente (402) auf der zweiten Halbleiterscheibe (400) CMOS-Bauelemente, insbesondere solche Schaltkreise sind.

14. Verfahren nach einem der vorangegangenen Ansprüche, wobei die ersten Bauelemente (302, 304) auf der ersten Halbleiterscheibe (300) LEDs, Hallsensoren, optische Filter oder MEMS-Elemente sind.

15. Verfahren nach einem der vorangegangenen Ansprüche, wobei die ersten Bauelemente (302, 304) auf der ersten Halbleiterscheibe (300) CMOS-Bauelemente, insbesondere solche Schaltkreise und die zweiten Bauelemente (402) auf der zweiten Halbleiterscheibe (400) GaN-Bauelemente sind.

16. Verfahren nach einem der vorangegangenen Ansprüche, wobei die erste Halbleiterscheibe (300) und die zweite Halbleiterscheibe (400) unterschiedlich voneinander sind, insbesondere unterschiedlich in der Materialart, in der Kristallorientierung, in dem Scheibendurchmesser und/oder in der Scheibendicke.

17. Verfahren nach einem der vorangegangenen Ansprüche, wobei die ersten und zweiten Bauelemente (302, 304, 402) unterschiedlich voneinander sind, insbesondere unterschiedlich in der Materialart, in der Kristallorientierung, in der Geometrie und/oder in der Dicke.

18. Verfahren nach einem der vorangegangenen Ansprüche, wobei die ersten Bauelemente (302,304) auf der ersten Halbleiterscheibe (300) vor den ersten Transferdruckschritten nach einem Freiätzen der ersten Bauelemente (302, 304) aus der ersten Halbleiterscheibe (300) vor dem Bereitstellen (302) lateral von den Anbinde-Elementen gehalten werden.

## Claims

1. **Method of manufacturing** semiconductor devices, the method comprising the following steps
(a') providing (102) a first semiconductor wafer (300) having first predominantly functional devices (304) and a few first non-functional devices (302) in a first pitch (x,y), wherein the first devices (302,304) are laterally held on the first semiconductor wafer (300) by tethering elements;
(b') providing (102) a second semiconductor wafer (400) having second devices (402) in a second pitch (x',y');
(a) removing (108) the non-functional first devices (302) from the first semiconductor wafer (300) in first individual transfer printing steps;
(b) transferring (110) a plurality of the first functional devices (304) from the first wafer (300) to the associated second devices (402) of the second wafer (400) in a second transfer printing step;
(c) transferring (112) individual functional first components (304) of the first semiconductor wafer (300) to second components (408) without printed first components in third respective individual transfer printing steps;
(a") depositing at least one insulator layer and/or at least one conductive layer on the second semiconductor wafer;
(b") patterning (structuring) the at least one insulator layer and/or the at least one conductive layer on the second semiconductor wafer.

2. Method according to claim 1, wherein in the second transfer printing step the functional first components (304) are transferred in a third raster to the components (402) of the second semiconductor wafer (400), so that after the second transfer printing step there are on the second semiconductor wafer (400) second components with a printed first functional component (404) and second components (408) still without a printed first component.

3. Method according to claim 1 or 2, the method further comprising:
(c') detecting (104) non-functional first devices (302) on the first semiconductor wafer (300) before they are removed in the first transfer printing steps.

4. Method according to claim 3, wherein non-functional first components (302) are detected by an optical or electrical method, in particular by an automatic optical or electrical inspection or measurement.

5. Method according to any one of the preceding claims, wherein the first transfer printing steps are a plurality of transfer printing steps designed for individual components (302).

6. Method of claim 1 or 5, wherein a transfer stamp is used for the first single component designed transfer printing steps, the transfer stamp being designed to receive a single first non-functional component (302).

7. Method according to any one of claims 1 to 4, wherein a plurality of transfer stamps operating in parallel are used for the first transfer printing steps designed for individual components, each transfer stamp being designed to receive a single first non-functional component (302).

8. Method according to any one of the preceding claims, wherein the first semiconductor wafer (300) and the second semiconductor wafer (400) have the same wafer diameter.

9. Method according to any one of the preceding claims, wherein a transfer die is used for the second transfer printing step, the transfer die being configured to receive a plurality of first functional devices (304) on the first semiconductor wafer (300).

10. Method according to any one of the preceding claims, wherein the third transfer printing steps are transfer printing steps designed for individual components (304).

11. Method according to any one of the preceding claims, wherein a transfer stamp is used for the third, single component transfer printing steps, the transfer stamp being adapted to receive a single first functional component (304).

12. Method according to any one of the preceding claims, wherein a plurality of transfer dies/stamps operating in parallel are used for the third transfer printing steps designed for individual components, each transfer die being designed to receive a single first functional component (304).

13. Method according to any one of the preceding claims, wherein the first devices (302, 304) on the first semiconductor wafer (300) are GaN devices and the second devices (402) on the second semiconductor wafer (400) are CMOS devices, in particular such circuits.

14. Method according to any one of the preceding claims, wherein the first devices (302, 304) on the first semiconductor wafer (300) are LEDs, Hall sensors, optical filters or MEMS elements.

15. Method according to any one of the preceding claims, wherein the first devices (302, 304) on the first semiconductor wafer (300) are CMOS devices, in particular such circuits, and the second devices (402) on the second semiconductor wafer (400) are GaN devices.

16. Method according to any one of the preceding claims, wherein the first semiconductor wafer (300) and the second semiconductor wafer (400) are different from each other, in particular different in the type of material, in the crystal orientation, in the wafer diameter and/or in the wafer thickness.

17. Method according to any one of the preceding claims, wherein the first and second components (302, 304, 402) are different from each other, in particular different in material type, crystal orientation, geometry and/or thickness.

18. Method of any one of the preceding claims, wherein the first devices (302,304) on the first semiconductor wafer (300) are laterally held by the tethering elements prior to the first transfer printing steps after a free etching of the first devices (302,304) from the first semiconductor wafer (300) prior to the providing (302).

## Revendications

1. **Procédé de fabrication** de dispositifs à semi-conducteurs, le procédé comprenant les étapes suivantes
(a') la mise à disposition (102) d'une première plaquette semi-conductrice (300) avec des premiers composants principalement fonctionnels (304) et quelques premiers composants non fonctionnels (302) dans une première trame (x, y), les premiers composants (302, 304) étant maintenus latéralement sur la première plaquette semi-conductrice (300) par des éléments d'attache ;
(b') fournir (102) une deuxième plaquette semi-conductrice (400) avec des deuxièmes composants (402) dans une deuxième grille (x', y') ;
(a) l'enlèvement (108) des premiers composants non fonctionnels (302) de la première plaquette semi-conductrice (300) dans des premières étapes d'impression par transfert respectivement individuelles ;
(b) transférer (110) une pluralité des premiers composants fonctionnels (304) de la première plaquette semi-conductrice (300) aux seconds composants associés (402) de la seconde plaquette semi-conductrice (400) dans une seconde étape d'impression par transfert ;
(c) transférer (112) de premiers composants fonctionnels individuels (304) de la première plaquette semi-conductrice (300) sur des deuxièmes composants (408) sans premiers composants imprimés dans des troisièmes étapes d'impression de transfert respectivement individuelles ;
(a") déposer au moins une couche isolante et/ou au moins une couche conductrice sur la seconde plaquette semi-conductrice ;
(b") structurer ladite au moins une couche isolante et/ou ladite au moins une couche conductrice sur ladite seconde plaquette semi-conductrice.

2. Procédé selon la revendication 1, dans lequel, lors de la deuxième étape d'impression par transfert, les premiers composants fonctionnels (304) sont transférés dans une troisième trame sur les composants (402) de la deuxième plaquette semi-conductrice (400), de sorte qu'après la deuxième étape d'impression par transfert, on trouve sur la deuxième plaquette semi-conductrice (400) des deuxièmes composants avec un premier composant fonctionnel imprimé (404) et des deuxièmes composants (408) encore sans un premier composant imprimé.

3. Procédé selon la revendication 1 ou 2, ledit procédé comprenant en outre :
(c') détecter (104) des premiers composants non fonctionnels (302) sur la première plaquette semi-conductrice (300) avant qu'ils ne soient retirés lors des premières étapes d'impression par transfert.

4. Procédé selon la revendication 3, dans lequel des premiers composants non fonctionnels (302) sont détectés par un procédé optique ou électrique, en particulier par une inspection ou une mesure optique ou électrique automatique.

5. Procédé selon l'une quelconque des revendications précédentes, dans lequel les premières étapes d'impression par transfert sont plusieurs étapes d'impression par transfert conçues pour des composants individuels (302).

6. Procédé selon la revendication 1 ou 5, dans lequel, pour les premières étapes d'impression par transfert conçues pour des composants individuels, on utilise un tampon de transfert qui est conçu de telle sorte que le tampon de transfert reçoit un premier composant non fonctionnel individuel (302).

7. Procédé selon l'une quelconque des revendications 1 à 4, dans lequel, pour les premières étapes d'impression par transfert conçues pour des composants individuels, on utilise plusieurs poinçons de transfert fonctionnant en parallèle, qui sont conçus pour recevoir chacun un premier composant non fonctionnel individuel (302).

8. Procédé selon l'une quelconque des revendications précédentes, dans lequel la première plaquette semi-conductrice (300) et la deuxième plaquette semi-conductrice (400) ont le même diamètre de plaquette.

9. Procédé selon l'une quelconque des revendications précédentes, dans lequel on utilise pour la deuxième étape d'impression par transfert un tampon de transfert configuré pour que le tampon de transfert reçoive une pluralité de premiers composants fonctionnels (304) sur la première plaquette semi-conductrice (300).

10. Procédé selon l'une quelconque des revendications précédentes, dans lequel les troisièmes étapes d'impression par transfert sont des étapes d'impression par transfert conçues pour des composants individuels (304).

11. Procédé selon l'une quelconque des revendications précédentes, dans lequel, pour les troisièmes étapes d'impression par transfert conçues pour des composants individuels, on utilise un poinçon de transfert qui est conçu de telle sorte que le poinçon de transfert reçoive un premier composant fonctionnel individuel (304).

12. Procédé selon l'une quelconque des revendications précédentes, dans lequel, pour les troisièmes étapes d'impression par transfert conçues pour des composants individuels, on utilise plusieurs poinçons de transfert fonctionnant en parallèle et conçus pour recevoir chacun un premier composant fonctionnel individuel (304).

13. Procédé selon l'une des revendications précédentes, dans lequel les premiers composants (302, 304) sur la première plaquette semi-conductrice (300) sont des composants GaN et les deuxièmes composants (402) sur la deuxième plaquette semi-conductrice (400) sont des composants CMOS, notamment des circuits de ce type.

14. Procédé selon l'une des revendications précédentes, dans lequel les premiers composants (302, 304) sur la première plaquette semi-conductrice (300) sont des LED, des capteurs à effet Hall, des filtres optiques ou des éléments MEMS.

15. procédé selon l'une des revendications précédentes, dans lequel les premiers composants (302, 304) sur la première plaquette semi-conductrice (300) sont des composants CMOS, notamment des circuits de ce type, et les deuxièmes composants (402) sur la deuxième plaquette semi-conductrice (400) sont des composants GaN.

16. Procédé selon l'une quelconque des revendications précédentes, dans lequel la première plaquette semi-conductrice (300) et la deuxième plaquette semi-conductrice (400) sont différentes l'une de l'autre, notamment différentes en termes de type de matériau, d'orientation cristalline, de diamètre de plaquette et/ou d'épaisseur de plaquette.

17. Procédé selon l'une quelconque des revendications précédentes, dans lequel les premiers et seconds composants (302, 304, 402) sont différents les uns des autres, notamment différents en termes de type de matériau, d'orientation cristalline, de géométrie et/ou d'épaisseur.

18. Procédé selon l'une quelconque des revendications précédentes, dans lequel les premiers composants (302, 304) sont maintenus latéralement par les éléments de liaison sur la première plaquette semi-conductrice (300) avant les premières étapes d'impression par transfert après une gravure libre des premiers composants (302, 304) hors de la première plaquette semi-conductrice (300) avant la fourniture (302).
